(19) Europäisches Patentamt
European Patent Office
Office européen des brevets

(11) **EP 3 229 278 B1**

(12) **EUROPEAN PATENT SPECIFICATION**

(45) Date of publication and mention
of the grant of the patent:
**09.08.2023 Bulletin 2023/32**

(21) Application number: **16168987.2**

(22) Date of filing: **10.05.2016**

(51) International Patent Classification (IPC):
*H01L 31/103* (2006.01)    *H01L 31/18* (2006.01)

(52) Cooperative Patent Classification (CPC):
**H01L 31/103; H01L 31/1804**

(54) **SENSOR DEVICE AND METHOD FOR MANUFACTURING A SENSOR DEVICE**

SENSORVORRICHTUNG UND VERFAHREN ZUR HERSTELLUNG DER SENSORVORRICHTUNG

DISPOSITIF DE DÉTECTION ET PROCÉDÉ DE FABRICATION ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.04.2016 US 201662319416 P**

(43) Date of publication of application:
**11.10.2017 Bulletin 2017/41**

(73) Proprietor: **ams AG**
**8141 Premstätten (AT)**

(72) Inventors:
• **ROGER, Frederic**
**8045 Graz (AT)**

• **EILMSTEINER, Gerhard**
**8700 Leoben (AT)**
• **DIERSCHKE, Eugene G.**
**Dallas, TX 75248 (US)**

(74) Representative: **Epping - Hermann - Fischer
Patentanwaltsgesellschaft mbH
Schloßschmidstraße 5
80639 München (DE)**

(56) References cited:
**EP-A1- 0 387 483          WO-A2-97/29517
US-A1- 2013 341 690      US-A1- 2015 338 273
US-A1- 2016 035 914**

## Description

The invention relates to a sensor device, in particular a semiconductor sensor device, for detecting incident ultraviolet, UV, radiation. More specifically, the invention relates to a sensor device with a photodiode structure for detecting UV radiation. The invention further relates to a manufacturing method for such a sensor device.

Sensors for detecting UV radiation may for example be utilized to evaluate an impact of light, for example sunlight, on human skin. For example, skin burn is mainly caused by an interaction of the skin with a combination of UV-A and UV-B photons with wavelengths for example between 280 nm and 400 nm.

EP 0387483 A1 relates to a photodiode arrangement for monitoring flames in furnaces. The arrangement comprises two photodiodes with different sensitivities in the UV regime, wherein a measurement signal is generated based on the difference of the photocurrents of the two photodiodes.

WO 97/29517 A2 discloses a UV radiation detector for monitoring flames in furnaces. The UV radiation detector integrates a photodiode and an electronic evaluation system with bipolar transistors on a semiconductor substrate.

US 2013/0341690 A1 discloses a UV light sensing device comprising a light incident surface and a plurality of semiconductor regions differing from each other in terms of type of conductivity and density.

Existing sensors for detecting UV radiation may also be sensitive to photons of light other than UV radiation, for example visible light and/or infrared radiation. Consequently, an accuracy of such sensors with respect to a desired UV response may be reduced.

It is therefore an object to provide an improved concept for detecting UV radiation with an improved accuracy.

This object is achieved by the subject matter of the independent claims. Further implementations and embodiments are the subject matter of the dependent claims.

The improved concept is based on a sensor device comprising a superposition of two wells, in particular two ion implanted wells, with opposite types of electrical conductivity within a semiconductor substrate. The semiconductor substrate has a first type of electrical conductivity, while a first well has a second type and a second well has the first type. By adjusting doping concentrations or profiles of the wells, a photon capturing layer having the second type of electrical conductivity is formed at a main surface of the semiconductor substrate. A p-n junction formed between the photon capturing layer and the second well is usable for detecting incident ultraviolet, UV, radiation. Advantageously, such a sensor device is predominantly sensitive to UV radiation and the sensitivity to visible light or infrared radiation is reduced.

Herein, the expression "light" refers to visible light, UV radiation and infrared radiation if not stated otherwise.

According to the improved concept a sensor device comprising a semiconductor substrate with a first type of electrical conductivity and with a photodiode structure for detecting incident UV radiation is provided. The photodiode structure comprises a first well arranged within the semiconductor substrate and having a second type of electrical conductivity, the second type being opposite to the first type. The photodiode structure further comprises a second well arranged at least partially within the first well and having the first type of electrical conductivity.

A doping concentration of the first well within a surface region at a main surface of the semiconductor substrate is greater than a doping concentration of the second well within the surface region. Thereby, a photon capturing layer having the second type of electrical conductivity is formed at the main surface. Furthermore, a p-n junction for detecting the incident UV radiation is formed by a boundary between the second well and the photon capturing layer.

The first and the second well may for example be generated by respective ion implantation processes, in particular retrograde ion implementation processes.

The doping concentrations of the first and the second well correspond for example to respective carrier concentrations at specified conditions, in particular at the same temperature, and/or to respective dopant concentrations.

According to some implementations of the sensor device, the first well is deeper than the second well. In particular, a boundary between the first well and the semiconductor substrate has a greater vertical distance from the main surface than a boundary between the first well and the second well. Therein, said boundaries correspond to boundaries in vertical direction.

Here and in the following, the expression "vertical" refers to a direction perpendicular to the main surface of the semiconductor substrate. "Laterally" refers to a direction parallel to the main surface.

Due to the described superposition of the first and the second well and the resulting formation of the photon capturing layer, predominantly UV radiation may be absorbed within the photon capturing layer and an absorption of visible light and/or infrared radiation within the photon capturing layer may be reduced due to a greater penetration depth of visible light and infrared radiation into a semiconductor material of the semiconductor substrate compared to UV radiation. Thus, an impact of visible light and/or infrared radiation is reduced and the measurement accuracy for UV radiation is improved.

Furthermore, due to the described superposition of the first and the second well, a stack of regions with alternating types of electrical conductivity may be generated. In particular, starting from the main surface in vertical direction, the type of electrical conductivity changes from the first type in the photon capturing layer to the second type in the second well to the first type in the first well and to the second type in the semiconductor substrate.

Consequently, the photon capturing layer is effectively isolated electrically and optically from deeper lying regions within the first and the second well and the semiconductor substrate. Therefore, detection of parasitic photocurrent generated in these regions for example by high wavelength photons may be avoided. Hence, an impact of visible light and infrared radiation may be further reduced and the measurement accuracy for UV radiation may be further improved.

According to some implementations of the sensor device, the p-n junction for detecting the incident UV radiation is predominantly sensitive to UV radiation and has for example a reduced sensitivity to visible light and/or infrared radiation.

This may for example be achieved by adjusting a vertical distance of the p-n junction from the main surface, for example by adjusting the doping profiles of the first and the second well. To this end, in particular implantation doses, implantation energies, implantation angles and/or further parameters of the ion implantation processes may be adjusted. According to some implementations of the sensor device, the vertical distance of the p-n junction is adjusted such that UV radiation is predominantly observed within the photon capturing layer and an absorption of visible light and/or infrared radiation within the photon capturing layer is reduced or minimized for example due to a higher penetration depth of visible light and/or infrared radiation compared to a maximum penetration depth of UV radiation in the semiconductor material.

According to some implementations of the sensor device, a carrier concentration within the photon capturing layer has a value between $1 \times 10^{16}$ carriers/cm$^3$ and $1 \times 10^{18}$ carrier/cm$^3$, for example in the order of $10^{17}$ carriers/cm$^3$, for example between $1 \times 10^{17}$ carriers/cm$^3$ and $5 \times 10^{17}$ carriers/cm$^3$.

According to the invention, the sensor device further comprises at least one sense terminal connected to the photon capturing layer for measuring a photocurrent generated by the incident UV radiation within a depletion region of the p-n junction. The measured photocurrent is for example a measure for an amount of the incident UV radiation.

In particular, the photocurrent may be generated by electron-hole pairs generated by incident radiation, in particular UV radiation, in the depletion region.

According to the invention, the sensor device further comprises a processing unit connected to the at least one sense terminal and configured to determine a characteristic of light incident to the sensor device depending on the photocurrent.

According to some implementations of the sensor device, carriers corresponding to the second type of electrical conductivity have a greater carrier lifetime than carriers corresponding to the first type of electrical conductivity.

Since the at least one sense terminal is connected to the photon capturing layer for measuring the photocurrent and the photon capturing layer has the second type of electrical conductivity, such implementations may have a reduced response time due to the greater carrier lifetime.

For example, if the semiconductor material is silicon, the lifetime of electrons is greater than the lifetime of holes for example by a factor of approximately three. The greater lifetime is for example associated with a greater carrier mobility of electrons compared to holes. Thus, a response of the sensor device may be approximately 3 times faster if the second type of electrical conductivity is n-type and the first type of electrical conductivity is p-type compared to the opposite case.

According to some implementations of the sensor device, the vertical distance of the p-n junction from the main surface lies within a specified tolerance range around a maximum penetration depth for UV radiation into the semiconductor substrate, in particular into the semiconductor material of the semiconductor substrate.

The vertical distance of the p-n junction from the main surface defines a thickness or effective thickness of the photon capturing layer. The vertical distance of the p-n junction may particular be adjusted by the implantation parameters of the ion implementation processes.

The penetration depth of radiation into a material is for example given by a depth for which an intensity of the radiation penetrating the material has dropped from an initial value to a specified fraction of the initial value, for example to 1/e or approximately 1/e times the initial value, wherein e≈2.71828 represents Euler's number.

The maximum penetration depth for UV radiation corresponds for example to the penetration depth for radiation with a wavelength corresponding to an upper boundary of the UV range of radiation. The upper boundary of the UV range of radiation is for example given by a wavelength of 400 nm.

For example, for silicon the penetration depth for radiation with a wavelength of 400 nm, that is the maximum penetration depth for UV radiation, is 100 nm or approximately 100 nm.

According to some implementations of the sensor device, a lower boundary of the tolerance range is equal to or greater than 80%, preferably 90%, more preferably 100%, of the maximum penetration depth. According to some implementations, an upper boundary of the tolerance range is equal to or less than 300% of the maximum penetration depth. According to some implementations the upper boundary of the tolerance range is equal to or less than 150%, preferably 120%, more preferably 100%, of the maximum penetration depth. Therein, the listed values for the upper and lower boundary are to be interpreted as values up to manufacturing tolerances, especially for the value 100%.

If the vertical distance of the p-n junction is for example equal to the maximum penetration depth, the whole UV spectrum has a penetration depth lying within the photon capturing layer, while the penetration depth of visible light and infrared radiation does not lie within the photon capturing layer. This may lead to a particularly high accuracy of UV detection by the sensor device.

With respect to manufacturing restrictions, however, it may be advantageous to deviate from the exact value of the maximum penetration depth for the vertical distance of the p-n junction. In particular, if the vertical distance lies within the specified tolerance range around the maximum penetration depth for UV radiation, the achievable accuracy may be still improved and at the same time manufacturing requirements may be relaxed.

According to the invention, the sensor device further comprises a filter arranged above the photon capturing layer, the filter being configured to pass UV radiation at least partially and to block or attenuate visible light and infrared radiation.

Said filter is arranged above the main surface such that light incident on the sensor device passes the filter before hitting the photon capturing layer.

The accuracy of the UV detection is thereby further improved.

According to some implementations of the sensor device, the filter is implemented as an interference filter or as a dielectric filter.

According to some implementations of the sensor device, the filter is implemented as a hybrid filter, in particular a metal-dielectric hybrid filter.

The hybrid filter, in particular metal-dielectric hybrid filter, may for example comprise one or more stacks of alternating dielectric layers. In addition, one or more metal layers may for example be arranged between the one or more stacks of alternating dielectric layers.

By means of the one or more metal layers, especially visible light and/or infrared radiation may be blocked or attenuated in a particularly effective way. By means of the one or more stacks of alternating dielectric layers, for example the transmission characteristic of the filter within the UV range of radiation may be adjusted or achieved.

According to some implementations of the sensor device, each of the one or more stacks of alternating dielectric layers comprises layers of a first and a second dielectric material arranged in an alternating fashion.

According to some implementations of the sensor device, the first dielectric material comprises or consists of silicon dioxide.

According to some implementations of the sensor device, the second dielectric material comprises or consists of hafnium oxide, hafnium dioxide, tantalum oxide, tantalum monoxide, tantalum dioxide, tantalum pentoxide, zirconium oxide, zirconium dioxide, aluminum oxide, silicon nitride, amorphous silicon, niobium pentoxide and/or titanium dioxide.

According to some implementations of the sensor device, the one or more metal layers comprise or consist of aluminum.

According to some implementations of the sensor device, the filter has a specified transmission characteristic in the UV range of radiation. In this way, different types or different sub-ranges of UV radiation, such as for example UV-A and UV-B radiation, may for example be weighted differently.

According to the invention, a transmission characteristic of the filter emulates a specified erythema action spectrum.

In particular, "emulates" means that a relative transmission value of the filter as a function of radiation wavelength is, in particular within the UV range of radiation, in particular within the UV-A and the UV-B range of radiation, in particular between 280 nm and 400 nm radiation wavelength, proportional to the erythema action spectrum.

In general, the expression "relative transmission " describes a transmission compared to a maximum transmission value. Here, the relative transmission corresponds to the transmission of the filter compared to a maximum transmission value of the filter.

The erythema action spectrum specifies an impact of radiation, in particular UV radiation, on human skin. The erythema action spectrum is for example specified by the International Commission on Illumination (CIE).

According to some implementations of the sensor device, the characteristic of the incident light is for example a UV index of the incident light.

The UV index is for example a measure for sunburn-producing UV radiation. The UV index is for example defined as an integral of the erythema action spectrum multiplied with an irradiance of the incident light over wavelength.

With corresponding implementations of the sensor device according to the improved concept, it is therefore possible to directly measure the UV index with an improved accuracy.

Furthermore, if the transmission characteristic of the filter emulates the erythema action spectrum, the UV index may be determined with a single photodiode structure of the sensor device.

According to the invention, the sensor device further comprises an attenuation layer, in particular a structured attenuation layer, arranged on or above the main surface and configured to pass visible light and infrared radiation at least partially and to block or attenuate UV radiation. The photon capturing layer is laterally separated into at least two capturing portions. At least one first capturing portion of the at least two capturing portions is not covered by the attenuation layer and at least one second portion of the at least two capturing portions is covered by the attenuation layer.

Consequently, the at least one second capturing portion may be used to measure an amount of infrared radiation and visible light incident on the photon capturing layer. A corresponding measurement result can for example be used to correct a measured amount of UV light radiation measured by the at least one first capturing portion. This may for example be advantageous since the at least one first capturing portion may detect UV radiation as well as visible light and/or infrared radiation.

In particular, such implementations are advantageous since the sensor device also comprises the filter. Then, for example, deviations of the transmission characteristic of the filter from an ideal transmission characteristic may be compensated using the amount of infrared radiation and visible light measured by means of the at least one second capturing portion.

According to some implementations of the sensor device, the attenuation layer is arranged between the filter and the main surface.

According to some implementations of the sensor device, the attenuation layer comprises or consists of polysilicon, titanium dioxide or niobium pentoxide.

According to some implementations of the sensor device, the photon capturing layer is for example laterally separated into the at least two capturing portions by an electrically insulating material.

According to some implementations of the sensor device, the electrically insulating material comprises or consists of silicon dioxide.

The electrically insulating material may for example correspond to or be comprised by a field oxide structure or a shallow trench isolation, STI, structure.

According to the invention, the sensor device, in particular the at least one sense terminal, comprises a first sense terminal connected to the at least one first capturing portion for measuring a first channel signal depending on a photocurrent generated by UV radiation incident on the at least one first capturing portion, in particular photocurrent generated by the incident UV radiation within a depletion region of a portion of the p-n junction formed by a boundary between the second well and the at least one first capturing portion. The sensor device, in particular the at least one sense terminal, comprises a second sense terminal connected to the at least one second capturing portion for measuring a second channel signal depending on a photocurrent generated by UV radiation incident on the at least one second capturing portion, in particular photocurrent generated by the incident UV radiation within a depletion region of a portion of the p-n junction formed by a boundary between the second well and the at least one second capturing portion.

According to the invention, the sensor device further comprises the processing unit. The processing unit is connected to the first and the second sense terminal and configured to determine the characteristic of the incident light depending on a difference between a signal depending on the first channel signal and a signal depending on the second channel signal.

According to some implementations of the sensor device, the characteristic of the incident light depends on a UV portion of the incident light.

In some implementations, the characteristic of the incident light is given by or depends on an amount or relative amount of radiation within the UV range of radiation or within a sub-range of the UV range of radiation. For example, the sub-range may correspond to a UV-A and/or a UV-B range of radiation.

In some implementations, the characteristic of the incident light is given by or depends on an intensity distribution of the incident light within the UV range of radiation or the sub-range. For example, the intensity distribution may correspond to the erythema action spectrum or a part of it, in particular a part lying within the UV-A range or the UV-B range.

According to some implementations of the sensor device, the signal depending on the first channel signal is given by the first channel signal or a weighted first channel signal and the signal depending on the second channel signals given by the second channel signal or a weighted second channel signal.

The weighted first channel signal is for example given by the first channel signal multiplied with a first weighting factor and the weighted second channel signal is for example given by the second channel signal multiplied with a second weighting factor. The first and the second weighting factors may for example account for deviations from an ideal transmission characteristic of the filter and/or the attenuation layer. Alternatively or in addition, the first and the second weighting factors may for example account for spatial variations of photosensitivity for example due to process variations.

According to some implementations which are not part of the present invention, the sensor device comprises a further photodiode structure implemented in the same way as the photodiode structure.

Therein, the further photodiode structure being implemented in the same way as the photodiode structure means that the further photodiode structure has further components corresponding to the components of the photodiode structure. The further components have the same structure and characteristic and serve for the same purpose as the components of the photodiode structure. In particular, the further photodiode structure may be implemented identically to the photodiode structure.

According to some implementations of the sensor device, the further photodiode structure comprises a further first well arranged within the semiconductor substrate and having the second type of electrical conductivity and a further second well arranged at least partially within the further first well and having the first type of electrical conductivity. A dopant concentration of the further first well within a further surface region at the main surface is greater than a dopant concentration of the further second well within the further surface region. Thereby, a further photon capturing layer having the second type of electrical conductivity is formed that the main surface. Furthermore, a further p-n junction for detecting the incident UV radiation is formed by a boundary between the further second well at the further photon capturing layer.

Further implementations of the further photodiode structure follow readily from the various implementations of the sensing device described above with respect to the photodiode structure.

According to the invention, also a method for manufacturing a sensor device for detecting incident UV radiation is provided, as defined in the appended claim 5. The method comprises providing a semiconductor substrate with a first type of electrical conductivity and generating a photodiode structure. The generation of the photodiode structure comprises generating a first well arranged within the semiconductor substrate and having a second type of electrical conductivity and generating a second well arranged at least partially within the first well and having the first type of electrical conductivity. The first well is generated by performing a first ion implementation process and the second well is generated by performing a second ion implantation process.

A dopant concentration of the first well within a surface region at a main surface of the semiconductor substrate is greater than a dopant concentration of the second well within the surface region. Thereby, a photon capturing layer having the second type of electrical conductivity is formed at the main surface. Furthermore, a p-n junction sensitive to the incident UV radiation is formed by a boundary between the second well and the photon capturing layer.

According to some implementations of the method, each of the first and the second ion implementation process comprises one or more ion implementation steps.

The one or more ion implementation steps of one of the first and the second ion implantation process may have different implantation parameters such as implantation dose, implantation angle and/or implantation energy.

According to some implementations of the method, the first and/or the second ion implantation process comprises one or more thermal steps for example for achieving desired doping profiles of the first and/or the second well.

According to some implementations of the method, the first and the second ion implantation processes are retrograde ion implantation processes.

Therein, the retrograde ion implantation processes are implantation processes adjusted to generate a retrograde doping profile. A retrograde doping profile has for example a peak of dopant concentration being buried with a nonzero peak depth beneath the main surface. A dopant concentration increases for example from the main surface to the peak depth. In particular, the retrograde doping profile may differ from a diffuse doping profile in this respect.

Retrograde doping processes may for example be achieved by means of ion implantation processes utilizing a particularly high implantation energy, for example in the order of hundred or several hundreds of keV or in the order of one or several MeV, for example between 100 keV and few MeV.

According to some implementations of the method, the first and second well are retrograde wells, in particular have retrograde doping profiles.

For example, the first and the second ion implementation process may be part of a standard CMOS process or a high-voltage CMOS process. Consequently, no dedicated ion implementation processes may have to be developed to realize a method according to the improved concept.

According to some implementations of the method, the generation of the photodiode structure further comprises performing a third ion implantation process after the first and the second ion implantation process to increase a carrier concentration of the photon capturing layer.

In this way, for example the vertical distance of the p-n junction from the main surface may be increased. Furthermore, process stability regarding the photon capturing layer may be improved.

According to some implementations of the method, a carrier concentration within the photon capturing layer has a value between $1 \times 10^{16}$ carriers/cm$^3$ and $1 \times 10^{18}$ carrier/cm$^3$, for example in the order of $10^{17}$ carriers/cm$^3$, for example between $1 \times 10^{17}$ carriers/cm$^3$ and $5 \times 10^{17}$ carriers/cm$^3$.

According to some implementations of the method, the same type of dopants is used for the third and the first ion implantation process.

Further implementations of the method are readily derived from the various implementations of the sensor device and vice versa.

In the following, the invention is explained in detail with the aid of exemplary implementations by reference to the drawings. Components that are functionally identical or have an identical effect may be denoted by identical references.

Identical components and/or components with identical effects may be described only with respect to the figure where they occur first and their description is not necessarily repeated in subsequent figures. All features of specific implementations may be combined with other implementations if not stated otherwise.

In the drawings,

Figure 1 shows a cross-section of an exemplary implementation of a sensor device not being part of the present invention;

Figure 2 shows a doping profile of an exemplary implementation of a photodiode structure in a sensor device not being part of the present invention;

Figure 3 shows the penetration depth of radiation in silicon as a function of wavelength;

Figure 4 shows relative responsivities of a sensor device according to the improved concept and of a conventional sensor device;

Figure 5 shows a cross-section of an implementation of a sensor device according to the present invention;

Figure 6 shows the erythema action spectrum as a function of wavelength; and

Figures 7A, 7B, 8A, 8B, 9A and 9B show the relative transmission of exemplary implementations of filters or further filters for use in a sensor device according to the improved concept as a function of wavelength.

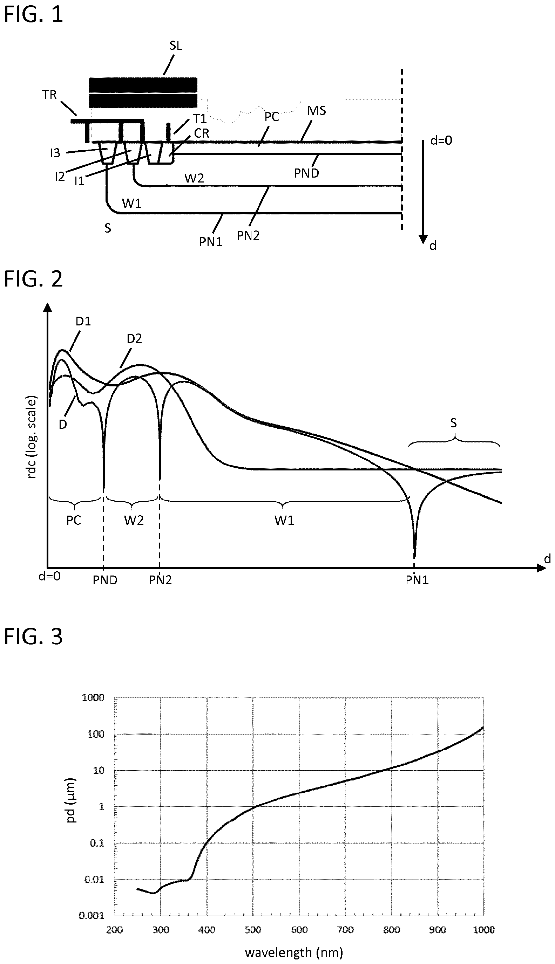

Figure 1 shows a cross-section of an exemplary implementation of a sensor device.

The sensor device is for example implemented in a semiconductor wafer or a semiconductor die and/or is part of an integrated circuit.

The sensor device comprises a semiconductor substrate S comprising a semiconductor material, for example silicon, and having a first type of electrical conductivity, for example p-type conductivity. The sensor device further comprises a first well W1 arranged within the semiconductor substrate S and having a second type of electrical conductivity opposite to the first type, the second type being for example n-type conductivity. The sensor device further comprises a second well W2 arranged for example within the first well W1 and having the first type of electrical conductivity. Consequently, a first p-n junction PN1 is formed by a boundary between the semiconductor substrate S and the first well W1 and a second p-n junction PN2 is formed by a boundary between the first well W1 and the second well W2.

Within a surface region at a main surface MS of the semiconductor substrate S, a doping concentration, in particular a carrier concentration, of the first well W1 is greater than a doping concentration, in particular a carrier concentration, of the second well W2. Therefore, a photon capturing layer PC having the second type of electrical conductivity is formed at the main surface MS, in particular in the surface region. Thus, a detection p-n junction PND is formed by a boundary between the second well W2 and the photon capturing layer PC.

Herein, a part of the second well W2 not corresponding to the photon capturing layer PC is denoted as the second well W2 and a part of the first well W1 neither corresponding to the second well W2 nor to the photon capturing layer PC is denoted as the first well W1.

The sensor device may for example have an optional contact region CR having the second type of electrical conductivity within the semiconductor substrate for contacting the photon capturing layer PC.

The sensor device further comprises a first sense terminal T1 connected to the photon capturing layer PC, for example via the contact region CR. Furthermore, the sensor device may comprise a reference terminal TR connected to the semiconductor substrate S, the first well W1 and second well W2. In alternative implementations, the reference terminal TR may be connected to the semiconductor substrate S and the first well W1 and the sensor device may comprise a further reference terminal connected to the second well W2.

A photodiode structure of the sensor device is formed by the first and the second well W1, W2 and the resulting photon capturing layer PC. In particular, the detection p-n junction PND may be used to detect UV radiation. A photocurrent generated within the depletion region of the detection p-n junction PND is for example read out or measured via the first sense terminal T1.

For example, the photon capturing layer PC, in particular the contact region CR, may be electrically separated laterally from the second well W2 by a first portion of electrically insulating material I1. Analogously, the second well W2 and the first well W1 may be electrically separated laterally from each other by a second portion of electrically insulating material I2 and the first well W1 may be electrically separated laterally from the semiconductor substrate S by a third portion of electrically insulating material I3. The portions of electrically insulating material I1, I2, I3 may for example consist of silicon dioxide and may for example be comprised by a field oxide structure or an STI structure.

Figure 1 may for example show only a part of the sensor device as indicated by a vertical dashed line. The vertical dashed line may for example represent a line of symmetry, for example mirror symmetry or rotational symmetry, of the sensor device, in particular of the components of the sensor device shown Figure 1.

Optionally, the sensor device may comprise one or more side layers SL, for example one or more metal side layers. The side layers SL are for example arranged above the main surface MS to block or reflect light coming from besides the photon capturing layer PC and to prevent such light to hit the photon capturing layer PC.

The semiconductor substrate S may for example be formed by an epitaxial layer of a semiconductor wafer, for example an epitaxial silicon layer, for example an epitaxial $p^+$-layer or an epitaxial $p^-$-layer.

In other implementations, the semiconductor substrate S may be formed by a semiconductor layer of a semiconductor-on-insulator, SOI, wafer, for example a silicon layer of an SOI wafer.

Figure 2 shows a doping profile of an exemplary implementation of a photodiode structure in a sensor device, for example of the photodiode structure of the sensor device shown in Figure 1.

Figure 2 shows a doping concentration rdc, in particular a relative doping concentration, in arbitrary units on a logarithmic scale as a function of a vertical distance, or depth, d. The vertical distance d is zero at the main surface MS and increases in the direction vertical to the main surface MS pointing towards the interior of the semiconductor substrate S. This is depicted also in Figure 1.

In Figure 2, a first doping profile D1 of a first ion implantation process, in particular a first retrograde ion implantation process, is shown. By means of the first ion implantation process, for example the first well W1 may be generated. The first ion implantation process may comprise one or more first ion implementation steps to achieve the desired profile D1. The first ion implantation process may generate the second type of electrical conductivity, for example n-type conductivity.

A second doping profile D2 of a second ion implantation process, in particular a second retrograde ion implantation process, is shown. By means of the second ion implantation process, for example the second well W2 may be generated. The second ion implantation process may comprise one or more second ion implementation steps to achieve the desired profile D2. The second ion implantation process may generate the first type of electrical conductivity, for example p-type conductivity.

A net doping profile D is shown representing an overall doping concentration caused by the first and the second ion implantation processes. It is pointed out, that a type of electrical conductivity is not reflected in a sign of the doping profiles D1, D2, D3. In this sense, the doping profiles D1, D2, D3 of Figure 2 show a an absolute value of the respective doping concentration.

In a region of the vertical distance d being greater than the vertical distance of the first p-n junction PN1, the doping concentration of the second doping profile D2 is greater than the doping concentration of the first doping profile D1. In the corresponding region of the semiconductor substrate S, the net doping profile D corresponds to the first type of electrical conductivity, in particular to the type of conductivity of the semiconductor substrate S, for example p-type conductivity.

In a region of the vertical distance d between the vertical distances of the first and the second p-n junction PN1, PN2, the doping concentration of the first doping profile D1 is greater than the doping concentration of the second doping profile D2. Consequently, in the corresponding region of the first well W1, the net doping profile D corresponds to the second type of electrical conductivity, for example n-type conductivity.

In a region of the vertical distance d between the vertical distances of the first p-n junction PN1 and the detection p-n junction PND, the doping concentration of the second doping profile D2 is greater than the doping concentration of the first doping profile D1. Consequently, in the corresponding region of the second well W2, the net doping profile D corresponds to the first type of electrical conductivity, for example p-type conductivity.

In a region of the vertical distance d between zero and the detection p-n junction PND, the doping concentration of the first doping profile D1 is greater than the doping concentration of the second doping profile D2. Consequently, the corresponding region of the second well W2, the net doping profile D corresponds to the second type of electrical conductivity, for example n-type conductivity.

Figure 3 shows the penetration depth pd of radiation in silicon as a function of wavelength on a logarithmic scale.

The UV range of radiation is for example defined as electromagnetic radiation with a wavelength in a range between 10 nm and 400 nm. The sub-range of UV-A radiation is for example defined as radiation with a wavelength in a range between 315 nm and 400 nm, while the sub-range of UV-B radiation is for example defined as radiation with a wavelength in a range between 280 nm and 315 nm. According to these definitions, visible light and infrared radiation have a wavelength greater than 400 nm.

As can be seen from Figure 3, a maximum penetration depth in silicon for UV radiation lies at 400 nm and has a value of approximately 100 nm. Consequently, a penetration depth in silicon lies below 100 nm for all wavelengths corresponding to UV radiation. For visible light and infrared radiation, the penetration depth in silicon is for example continuously increasing for wavelengths from 400 nm and above.

Referring now again to Figure 1, in operation of the sensor device, light, in particular UV radiation, visible light and infrared radiation may hit the sensor device, in particular the photon capturing layer PC. Consequently, electron-hole pairs are generated within the depletion region of the detection p-n junction PND generating a photocurrent that may be sensed via the first sense terminal T1.

In particular, a first channel signal CH1 may be detected depending on the photocurrent sensed via the first sense terminal T1. A characteristic C of the incident light may be obtained depending on the first channel signal as C ~ CH1.

In implementations where the second type of electrical conductivity is n-type, the photocurrent sense by the first sense terminal T1 corresponds to electron current. If the semiconductor material is for example silicon, the electron lifetime is approximately three times greater than the hole lifetime. Consequently, a response of the sensor device may be approximately three times faster than for implementations where the second type of electrical conductivity is p-type.

Due to the characteristics of the penetration depth in silicon as shown in Figure 3, a probability for visible light and/or infrared radiation to generate an electron-hole pair may be relatively high even for relatively large vertical distances d. In particular, a non-negligible amount of electron-hole pairs may be generated by visible light and/or infrared radiation within the regions of the second well W2, the first well W1 and the substrate S. On the other hand, the probability of electron-hole pairs being generated by visible light and/or infrared radiation within the photon capturing layer PC may be reduced.

Since the first sense terminal T1 is for example only connected to the photon capturing layer PC, a photocurrent generated in the mentioned deeper regions and detected via the first sense terminal T1 may be reduced. Furthermore, due to the alternating type of electrical conductivity of the substrate S the wells W1, W2 and the photon capturing layer PC, the detection p-n junction PND is effectively isolated from photocurrent generated in deeper regions, for example in the first well W1 or the semiconductor substrate S. This may lead to an improved accuracy of the UV detection. In particular it may lead to a reduced sensitivity of the sensor device to infrared radiation and/or visible light, while a sensitivity of the sensor device to UV radiation remains high.

The sensitivity of the sensor device to UV radiation compared to the sensitivity to infrared radiation and visible light may be improved or optimized by adjusting the vertical distance of the detection p-n junction PND. In particular, if the vertical distance of the detection p-n junction PND corresponds to the maximum penetration depth of UV radiation, for example 100 nm in silicon, the penetration depth for all UV radiation lies within the photon capturing layer PC, while the penetration depth for all visible light and infrared radiation lies outside, in particular below the photon capturing layer PC. Consequently, the generation of the electron-hole pairs by UV radiation is increased, while the generation of electron-hole pairs by infrared radiation and visible light is reduced.

This effect may be present also if the vertical distance of the detection p-n junction PND is not exactly equal to the maximum penetration depth for UV radiation. In particular, a considerable reduction of sensitivity of the sensor device to visible light and infrared radiation may be achieved already if the vertical distance of the detection p-n junction PND is equal to or less than 150% of the maximum penetration depth for UV radiation, for example 150 nm for silicon. To ensure a maximum sensitivity for UV radiation, the vertical distance of the detection p-n junction PND may lie for example at ot above 80% of the maximum penetration depth for UV radiation, for example 80 nm for silicon.

Since the detection p-n junction PDN is isolated from substrate parasitic visible and infrared photocurrent by being encapsulated in the first and the second well W1, W2, the sensitivity of the UV layer to the longer wavelengths may be significantly reduced and the UV response may be more accurate.

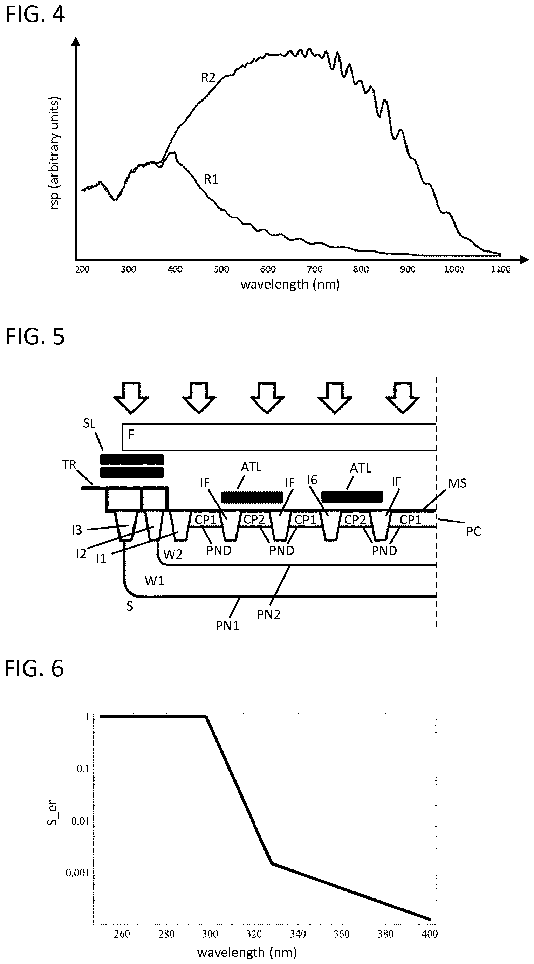

Figure 4 shows relative responsivities rsp of a sensor device according to the improved concept and of a conventional sensor device.

The responsivity rsp corresponds for example to the response of the photodiode in A/W on a light stimulus. For example, responsivity rsp is defined as measured photocurrent in A per radiant power in W of the incident light.

The curve R1 of Figure 4 corresponds to the responsivity rsp of a sensor device according to the improved concept, for example as described with respect to Figure 1, for example with silicon as the semiconductor material. The curve R2 corresponds to the responsivity of a conventional sensor device comprising a silicon photodiode with a junction depth of approximately 2 $\mu$m.

It can be clearly seen that the responsivity of the sensor device according to the improved concept drops significantly for wavelengths above 400 nm, that is for wavelength above the UV range. In contrast, the responsivity of the conventional sensor device increases for wavelengths above 400 nm and drops only in the infrared range. Consequently, an accuracy of the sensor device according to the improved concept with respect to the UV detection is for example significantly increased.

Figure 5 shows a cross-section of an exemplary implementation of a sensor device according to the present invention.

The sensor device of Figure 5 is for example based on the sensor device of Figure 1.

In the sensor device of Figure 5, the photon capturing layer PC is laterally separated into at least one first capturing portion CP1 and at least one second capturing portion CP2. In the example of Figure 5, the sensor device may comprise for example three first capturing portions CP1 and two second capturing portions CP2, the first and the second capturing portions being for example arranged in an alternating fashion. It is highlighted that the specific numbers of two and three capturing portions, respectively, are not limiting for only chosen as examples.

The capturing portions may for example correspond to stripe channels of the sensor device. The individual capturing portions CP1, CP2 are for example laterally separated by further portions of the electrically insulating material IF, which may for example consist of silicon dioxide, for example of the field oxide or STI structure.

The first sense terminal (not shown for the sake of clarity in Figure 5) is for example connected to each of the first capturing portions CP1 and a second sense terminal (not shown) is for example connected to each of the second capturing portions CP2.

Consequently, photocurrent generated in the portions of the depletion region of the detection p-n-junction PND corresponding to the first and the second capturing portions CP1, CP2 may be sensed via the first and the second sense terminal, respectively. In particular, a first channel signal CH1 may be detected depending on the photocurrent sensed via the first sense terminal and a second channel signal CH2 may be detected depending on the photocurrent sensed via the second sense terminal.

The sensor device of Figure 5 further comprises a structured attenuation layer ATL arranged on or above the main surface MS. The attenuation layer ATL is for example structured to cover the second capturing portions CP2 and leave open the first capturing portions CP1.

The attenuation layer ATL comprises for example a material blocking or attenuating UV radiation and passing visible light and infrared radiation at least partially.

Consequently, the first channel signal CH1 represents incident UV radiation as well as residual portions of infrared radiation and visible light. For example by subtracting the second channel signal CH2 from the first channel signal CH1, the characteristic C of the incident light may be obtained as C = CH1 - CH2. Alternatively, the characteristic C may be obtained according to the formula

$$C = K1 * CH1 - K2 * CH2, \qquad\qquad (1)$$

wherein K1 and K2 are respective weighting factors for the first and the second channel signal CH1, CH2.

The sensor device comprises a filter F arranged above the main surface MS. In particular, the attenuation layer ATL may be arranged between the filter F and the main surface.

The filter F is for example implemented as an interference filter, in particular a metal-dielectric hybrid filter. The filter F passes UV radiation at least partially and block or attenuate visible light and infrared radiation.

Consequently, an amount of visible light and infrared radiation hitting the photon capturing layer may be further reduced. The compensation factors K1, K2 may correct a deviation of a transmission characteristic of the filter F from an ideal characteristic.

Furthermore, the transmission characteristic of the filter F, in particular within the UV range, is adjusted to emulate the erythema action spectrum or a part of it. This is explained in more detail with respect to Figures 6 through 9B.

It is highlighted that, even though not shown in Figure 1, a filter F as in Figure 5 may also be comprised by the sensor device according to Figure 1.

Side incoming light protection may be achieved by the one or more side layers SL. In particular the one or more side layers SL may avoid unfiltered light, in particular unwanted visible and infrared light, coming from the side of the device and hitting the photon capturing layer PC.

Figure 6 shows the erythema action spectrum S_er as a function of wavelength.

The erythema action spectrum S_er is for example specified by the CIE and describes an impact of radiation, in particular UV radiation, on human skin. The UV index of light may for example be calculated as an integral of the erythema action spectrum S_er multiplied with an irradiance of the incident light over wavelength.

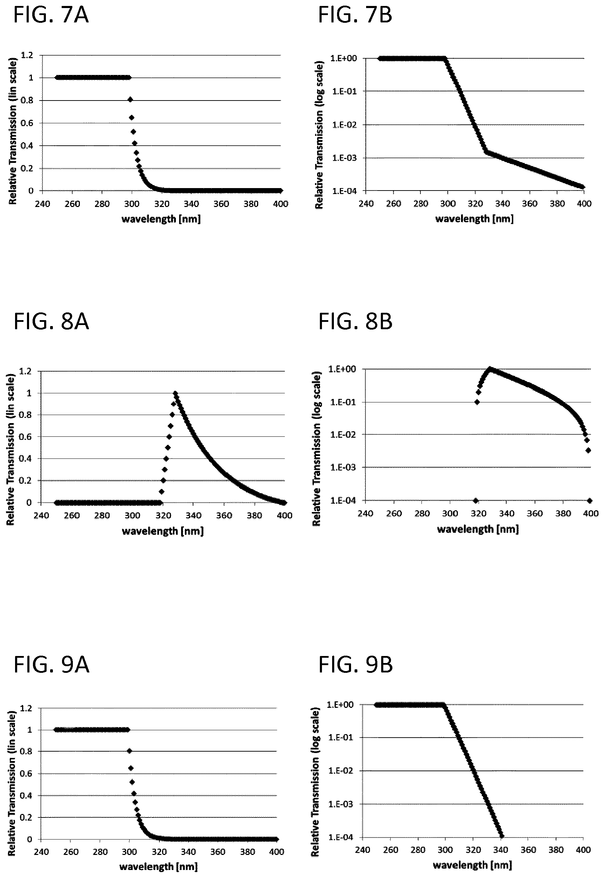

Figures 7A and 7B show the relative transmission of an exemplary implementation of the filter F for use in a sensor device according to the improved concept, in particular as in one of Figures 1 and 5, as a function of wavelength. Figures 7A and 7B show the same data on a linear and a logarithmic scale, respectively.

The relative transmission corresponds to the transmission of the filter F, normalized to a maximum transmission of the filter F.

A possible exemplary specification or a part of such specification for the filter F of Figures 7A and 7B is provided in Table 1. The filter F has for example a transition band within the UV range, for example below 400 nm, and a stop band in the range of visible light and infrared radiation, for example above 400 nm.

Table 1

| Category | Parameter | min. | typ. | max. | unit |
|---|---|---|---|---|---|
| Transition band | RT=50% (upper edge) IA=0°, T=25°C | 300 | 303 | 328 | nm |
| Transition band | RT transition from 80% to 20% (upper transition) T= 25°C | | | 30 | nm |
| Transition band | wavelength shift between IA=30° and IA=0°, RT=50%, T=25°C | | | 25 | nm |
| Stop band | Average RT, IA=0°, wavelength = 400nm to 1100nm, T=25°C | | | 0.01 | % |
| Stop band | Maximum RT, IA=0°, wavelength = 400nm to 1100nm, T=25°C | | | 0.1 | % |

In Table 1, RT denotes the relative transmission of the filter, while T and IA denote the ambient temperature and the incident angle of the incident light, respectively. "min.", "max." and "typ." correspond to minimum, maximum and typical values, respectively, of the respective specified parameters.

The filter F of Figures 7A and 7B emulates the erythema action spectrum S_er as can be seen in particular from a comparison of Figures 6 and 7B.

Consequently, in an implementation of the sensor device as in one of Figures 1 or 5 having a filter F as in Figures 7A and 7B, the characteristic C may represent the UV index or a measure for the UV index. Advantageously, the UV index may therefore be obtained by means of a sensor device according to the improved concept with only a single photodiode structure and the filter F.

Figures 8A and 8B show the relative transmission of a further exemplary implementation of the filter F for use in a sensor device according to the improved concept, in particular as in one of Figures 1 and 5, as a function of wavelength. Figures 8A and 8B show the same data on a linear and a logarithmic scale, respectively.

A possible exemplary specification or a part of such specification for the filter F of Figures 8A and 8B is provided in Table 2. The filter F has for example a transition band in the UV-A range, for example between 318 nm and 400 nm, and a stop band in the range of visible light and infrared radiation, for example above 400 nm.

Table 2

| Category | Parameter | min. | typ. | max | Unit |
|---|---|---|---|---|---|
| Transition band | RT=50% (lower edge) IA=0°, T=25°C | 318 | 323 | 328 | nm |
| Transition band | RT=50% (upper edge), IA=0°, T=25°C | 328 | 345 | 398 | nm |
| Transition band | RT transition from 20% to 80% (lower transition) T=25°C | | | 6 | nm |
| Transition band | RT transition from 80% to 20% (upper transition) T=25°C | | | 30 | nm |
| Transition band | wavelength shift between IA=30° and IA=0°, RT=50%, T=25°C | | | 25 | nm |
| Stop band | Average RT, IA=0°, wavelength = 400nm to 1100nm, T=25°C | | | 0.01 | % |
| Stop band | Maximum RT, IA=0°, wavelength = 400nm to 1100nm, T=25°C | | | 0.1 | % |

The filter F of Figures 8A and 8B emulates the UV-A part of erythema action spectrum S er as can be seen in particular from a comparison of Figures 6 and 8B.

Figures 9A and 9B show the relative transmission of a further exemplary implementation of the filter F for use in a sensor device according to the improved concept, in particular as in one of Figures 1 and 5, as a function of wavelength. Figures 9A and 9B show the same data on a linear and a logarithmic scale, respectively.

A possible exemplary specification or a part of such specification for the filter F of Figures 9A and 9B is provided in Table 3. The filter F has for example a transition band in the UV-B range, for example below 318 nm or below 328 nm, and a stop band for example above 318 nm or above 328 nm.

Table 3

| Category | Parameter | min. | typ. | max | Unit |
|---|---|---|---|---|---|
| Transition band | RT=50% (upper edge), IA=0°, T=25°C | 300 | 303 | 328 | nm |
| Transition band | RT transition from 80% to 20% (upper transition) T=25°C | | | 7 | nm |
| Transition band | wavelength shift between IA=30° and IA=0°, RT=50%, T=25°C | | | 25 | nm |
| Stop band | Average RT, IA=0°, wavelength = 328nm to 1100nm, T=25°C | | | 0.01 | % |
| Stop band | Maximum RT, IA=0°, wavelength = 328nm to 1100nm, T=25°C | | | 0.1 | % |

The filter F of Figures 9A and 9B emulates the UV-B part of erythema action spectrum S_er as can be seen in particular from a comparison of Figures 6 and 9B.

One may consider for example an implementation of the sensor device having an arrangement with a photodiode structure as in one of Figures 1 or 5 with a filter F as in Figures 8A and 8B and a further arrangement with a further photodiode structure as in one of Figures 1 or 5 with a further filter F as in Figures 9A and 9B.

A third channel signal CH3 may then be detected depending on a photocurrent sensed via a third sense terminal connected to the further photon capturing layer of the further photodiode structure.

The characteristic C may then for example be obtained as a sum of the first and the third channel signal as C = CH1 + CH3. Alternatively, the characteristic C may be obtained according to the formula

$$C = K1*CH1 + K3*CH3, \qquad (2)$$

wherein K1 and K3 are respective weighting factors for the first and the third channel signal CH1, CH3.

Since the filter F and the further filter F together emulate the erythema action spectrum S_er, the characteristic C may represent the UV index or a measure for the UV index also in this case. Such an arrangement with two photodiode structures and two respective filters F may have the advantage that the filters may be manufactured with higher accuracy.

In implementations where the photodiode structure and/or the further photodiode structure is implemented with at least two capturing portions CP and the attenuation layer ATL as described with respect to Figure 5, the characteristic may for example be determined according to the formula

$$C = K1*CH2 + K3*CH3 - K2*CH2, \qquad (3)$$

wherein K1, K2 and K3 are respective weighting factors for the first, the second and the third channel signal CH1, CH3.

In some implementations of the sensor device, in particular in implementations as shown in Figures 1 and 5, at least one of the first and the second sense terminal, the reference terminal and the further reference terminal may be connected by means of respective through-semiconductor-via, TSV, contacts to a backside of the semiconductor substrate S, the backside lying opposite to the main surface MS. In particular, the processing unit may be located on the backside of the semiconductor substrate. Such implementations may have the advantage that a shadowing of the photon capturing layer PC due to electrical contacts may be reduced or avoided. The use of TSV optical packaging may enable a direct exposure of the photodiode structure to UV photons without interconnection and layer interferences.

According to the improved concept, for example a sensor device based on dual or more photodiodes sensitive to UV wavelengths, one or two filters transparent to UV wavelength and following the erythema action spectrum S_er and blocking higher wavelengths may be obtained to extract the UV index response for incident light.

The sensor device may comprise a combination of a specific UV photodiode structure comprising a stack of two or three standard CMOS implantations forming a thin surface low doped layer, namely the photon capturing layer PC, for example of 100 nm thickness. This layer is for example dedicated to UV photon capture and may have a high responsivity for UV wavelengths and for example 5 to 10 times less responsivity in visible and infrared range compared to standard photodiodes. Layers generated underneath the photon capturing layer PC, namely by the wells W1, W2, may be used for the isolation of the photodiode structure to substrate parasitic photocurrent.

Further, the interference filter F may be applied being transparent to UV, or to UV-A or UV-B only, or to the erythema action spectrum S_er or to any specific UV signal, and blocking higher wavelengths. A dual photodiode system as in Figure 5 with the attenuation layer ATL and for example in TSV packaging may be used for isolating the UV signal of the total response.

Advantages of the improved concept may include the following. Only one type of photodiode structure may have to be used in order to limit the process variability impact on the response of the system. The photodiode structure may use only layers in standard or high voltage CMOS technology without exotic material such as Germanium or Gallium compounds or dedicated implantation processes.

The photon capturing layer PC may work with electrons of the photocurrent generated by the incoming light, which are faster than the holes of the photocurrent, electron carrier lifetime being for example three times greater than hole carrier lifetime in silicon.

The thickness of the photon capturing layer PC obtained by the combination of two or three standard well implantation processes may be around 100 nm which is the typical maximum penetration depth of the UV photons in silicon. A thickness of 100 nm may make the device less sensible to blue, green, red and infrared wavelengths and corresponding parasitic current with compared to a deeper junction depth.

The architecture of the diode by superposition of the wells W1, W2 may make the photon capturing layer PC less sensible to parasitic photocurrent generated by high wavelength photons. For example, electron photocurrent generated in the underneath p-layer of the second well W2 are captured partially by the underneath n-layer of the first well W1 and the photon capturing layer PC, and the underneath n-layer of the first well W1 may capture electron photocurrent generated in the substrate S.

The sensor device may use the combination of the dedicated photodiode structure and the UV filter F for reducing the impact of visible and infrared photons on the response of the system.

An improved determination of UV signal may be achieved by using a dedicated filter F transparent to UV with a better cut off and with less signal from higher wavelengths. By designing the UV filter requirement according to the erythema action spectrum S_er, one may achieve an improved accuracy for calculating the UV index.

Reference numerals

| | |
|---|---|
| S | semiconductor substrate |
| W1, W2 | wells |
| PC | photon capturing layer |
| MS | main surface |
| I1, I2, I3, IF | portions of electrically insulating material |
| CR | contact region |
| SL | side layers |
| T1, TR | terminals |
| D1, D2, D | doping profiles |
| PN1, PN2, PND | p-n junctions |
| R1, R2 | responsivity curves |
| F | filter |
| ATL | attenuation layer |
| CP1, CP2 | capturing portions |

**Claims**

1. Sensor device comprising a semiconductor substrate (S) with a first type of electrical conductivity and a photodiode structure for detecting incident ultraviolet, UV, radiation, the photodiode structure comprising

   - a first well (W1) arranged within the semiconductor substrate (S) and having a second type of electrical conductivity;
   - a second well (W2) arranged at least partially within the first well (W1) and having the first type of electrical conductivity, wherein a doping concentration of the first well (W1) within a surface region at a main surface (MS) of the semiconductor substrate (S) is greater than a doping concentration of the second well (W2) within the surface region, thereby forming at the main surface a photon capturing layer (PC) having the second type of electrical conductivity, wherein the photon capturing layer (PC) is laterally separated into at least two capturing portions (CP1, CP2);
   - a p-n junction (PND) for detecting the incident UV radiation formed by a boundary between the second well (W2) and the photon capturing layer (PC);
   - a filter (F) arranged above the photon capturing layer (PC), wherein a transmission characteristic of the filter (F) emulates a specified erythema action spectrum;
   - an attenuation layer (ATL) arranged on or above the main surface (MS) and configured to pass visible and infrared radiation at least partially and to block or attenuate UV radiation;
   - a first sense terminal (T1) connected to the at least one first capturing portion (CP1) for measuring a first channel signal depending on a photocurrent generated by UV radiation incident on the at least one first capturing portion (CP1);
   - a second sense terminal connected to the at least one second capturing portion (CP2) for measuring a second channel signal depending on a photocurrent generated by UV radiation incident on the at least one second capturing portion (CP2); and
   - a processing unit connected to the first sense terminal (T1) and the second sense terminal and configured to determine a characteristic of the incident light depending on a difference between a signal depending on the first channel signal and a signal depending on the second channel signal; wherein
   - at least one first capturing portion (CP1) of the at least two capturing portions (CP1, CP2) is not covered by the attenuation layer (ATL); and
   - at least one second capturing portion (CP2) of the at least two capturing portions (CP1, CP2) is covered by the attenuation layer (ATL).

2. Sensor device according to claim 1, where the first type of electrical conductivity is p-type and the second type of electrical conductivity is n-type.

**3.** Sensor device according to one of claims 1 to 2, wherein the p-n junction (PND) has a vertical distance from the main surface (MS) lying within a specified tolerance range around a maximum penetration depth for UV radiation into the semiconductor substrate (S).

**4.** Sensor device according to claim 3, wherein

- a lower boundary of the tolerance range is equal to or greater than 80 percent of the maximum penetration depth; and
- an upper boundary of the tolerance range is equal to or less than 150 percent of the maximum penetration depth.

**5.** Er. Method for manufacturing a sensor device for detecting incident UV radiation, the method comprising providing a semiconductor substrate (S) with a first type of electrical conductivity and generating a photodiode structure, the generation of the photodiode structure comprising

- generating a first well (W1) arranged within the semiconductor substrate (S) and having a second type of electrical conductivity by performing a first ion implantation process;
- generating a second well (W2) arranged at least partially within the first well (W1) and having the first type of electrical conductivity by performing a second ion implantation process, wherein a doping concentration of the first well (W1) within a surface region at a main surface (MS) of the semiconductor substrate (S) is greater than a doping concentration of the second well (W2) within the surface region, thereby forming, at the main surface (MS), a photon capturing layer (PC) having the second type of electrical conductivity, wherein the photon capturing layer (PC) is laterally separated into at least two capturing portions (CP1, CP2), wherein a p-n junction (PND) sensitive to the incident UV radiation is formed by a boundary between the second well (W2) and the photon capturing layer (PC);
- arranging a filter (F) above the photon capturing layer (PC), wherein a transmission characteristic of the filter (F) emulates a specified erythema action spectrum;
- forming an attenuation layer (ATL) arranged on or above the main surface (MS) and configured to pass visible and infrared radiation at least partially and to block or attenuate UV radiation;
- connecting a first sense terminal (T1) to the at least one first capturing portion (CP1) for measuring a first channel signal depending on a photocurrent generated by UV radiation incident on the at least one first capturing portion (CP1);
- connecting a second sense terminal to the at least one second capturing portion (CP2) for measuring a second channel signal depending on a photocurrent generated by UV radiation incident on the at least one second capturing portion (CP2); and
- connecting a processing unit to the first sense terminal (T1) and the second sense terminal, the processing unit being configured to determine a characteristic of the incident light depending on a difference between a signal depending on the first channel signal and a signal depending on the second channel signal; wherein
- at least one first capturing portion (CP1) of the at least two capturing portions (CP1, CP2) is not covered by the attenuation layer (ATL); and
- at least one second capturing portion (CP2) of the at least two capturing portions (CP1, CP2) is covered by the attenuation layer (ATL).

**6.** Method according to claim 5, wherein the first and the second ion implantation processes are retrograde ion implantation processes.

**7.** Method according to one of claims 5 or 6, wherein the generation of the photodiode structure further comprises performing a third ion implantation process after the first and the second ion implantation process to increase a carrier concentrating of the photon capturing layer (PC).

**8.** Method according to one of claims 5 to 7, wherein the first type of electrical conductivity is p-type and the second type of electrical conductivity is n-type.

**Patentansprüche**

**1.** Sensorvorrichtung umfassend ein Halbleitersubstrat (S) mit einem ersten Typ elektrischer Leitfähigkeit und eine Fotodiodenstruktur zum Erfassen einfallender ultravioletter, UV, wobei die Fotodiodenstruktur umfasst

- eine erste Wanne (W1), die innerhalb des Halbleitersubstrats (S) angeordnet ist und einen zweiten Typ von elektrischer Leitfähigkeit aufweist;

- eine zweite Wanne (W2), die zumindest teilweise innerhalb der ersten Wanne (W1) angeordnet ist und den ersten Typ elektrischer Leitfähigkeit aufweist, wobei eine Dotierungskonzentration der ersten Wanne (W1) innerhalb eines Oberflächenbereichs an einer Hauptoberfläche (MS) des Halbleitersubstrats (S) größer ist als eine Dotierungskonzentration der zweiten Wanne (W2) innerhalb des Oberflächenbereichs, wodurch an der Hauptoberfläche eine Photonenerfassungsschicht (PC) mit dem zweiten Typ elektrischer Leitfähigkeit gebildet wird, wobei die Photonenerfassungsschicht (PC) seitlich in mindestens zwei Erfassungsabschnitte (CP1, CP2) getrennt ist;

- einen p-n-Übergang (PND) zum Erfassen der einfallenden UV-Strahlung, der durch eine Grenze zwischen der zweiten Wanne (W2) und der Photonenerfassungsschicht (PC) gebildet wird;

- einen Filter (F), das über der Photonenerfassungsschicht (PC) angeordnet ist, wobei eine Durchlässigkeitscharakteristik des Filters (F) ein bestimmtes Erythemwirkungsspektrum emuliert;

- eine Abschwächungsschicht (ATL), die auf oder über der Hauptoberfläche (MS) angeordnet ist und dazu ausgelegt ist, dass sie sichtbare und infrarote Strahlung zumindest teilweise durchlässt und UV-Strahlung blockiert oder abschwächt;

- einen ersten Messanschluss (T1), der mit dem mindestens einen ersten Erfassungsabschnitt (CP1) verbunden ist, um ein erstes Kanalsignal zu messen, das von einem Fotostrom abhängt, der durch UV-Strahlung erzeugt wird, die auf den mindestens einen ersten Erfassungsabschnitt (CP1) einfällt;

- einen zweiten Messanschluss, der mit dem mindestens einen zweiten Erfassungsabschnitt (CP2) verbunden ist, um ein zweites Kanalsignal zu messen, das von einem Fotostrom abhängt, der durch UV-Strahlung erzeugt wird, die auf den mindestens einen zweiten Erfassungsabschnitt (CP2) einfällt; und

- eine Prozessoreinheit, die mit dem ersten Messanschluss (T1) und dem zweiten Messanschluss verbunden und dazu ausgelegt ist, dass sie eine Charakteristik des einfallenden Lichts in Abhängigkeit von einer Differenz zwischen einem von dem ersten Kanalsignal abhängigen Signal und einem von dem zweiten Kanalsignal abhängigen Signal bestimmt; wobei

- mindestens ein erster Erfassungsabschnitt (CP1) der mindestens zwei Erfassungsabschnitte (CP1, CP2) nicht durch die Abschwächungsschicht (ATL) abgedeckt ist; und

- mindestens ein zweiter Erfassungsabschnitt (CP2) der mindestens zwei Erfassungsabschnitte (CP1, CP2) durch die Abschwächungsschicht (ATL) abgedeckt ist.

2. Sensorvorrichtung nach Anspruch 1, wobei der erste Typ der elektrischen Leitfähigkeit vom p-Typ und der zweite Typ der elektrischen Leitfähigkeit vom n-Typ ist.

3. Sensorvorrichtung nach einem der Ansprüche 1 bis 2, wobei der p-n-Übergang (PND) einen vertikalen Abstand von der Hauptoberfläche (MS) aufweist, der innerhalb eines vorgegebenen Toleranzbereichs um eine maximale Eindringtiefe für UV-Strahlung in das Halbleitersubstrat (S) liegt.

4. Sensorvorrichtung nach Anspruch 3, wobei

- eine untere Grenze des Toleranzbereichs gleich oder größer als 80 Prozent der maximalen Eindringtiefe ist; und
- eine obere Grenze des Toleranzbereichs gleich oder kleiner als 150 Prozent der maximalen Eindringtiefe ist.

5. Verfahren zur Herstellung einer Sensorvorrichtung zum Erfassen von einfallender UV-Strahlung, wobei das Verfahren das Bereitstellen eines Halbleitersubstrats (S) mit einem ersten Typ elektrischer Leitfähigkeit und das Erzeugen einer Fotodiodenstruktur umfasst, wobei die Erzeugung der Fotodiodenstruktur umfasst

- Erzeugen einer ersten Wanne (W1), die innerhalb des Halbleitersubstrats (S) angeordnet ist und einen zweiten Typ elektrischer Leitfähigkeit aufweist, indem ein erster Ionenimplantationsprozess durchgeführt wird;

- Erzeugen einer zweiten Wanne (W2), die zumindest teilweise innerhalb der ersten Wanne (W1) angeordnet ist und den ersten Typ elektrischer Leitfähigkeit aufweist, indem ein zweiter Ionenimplantationsprozess durchgeführt wird, wobei eine Dotierungskonzentration der ersten Wanne (W1) innerhalb eines Oberflächenbereichs an einer Hauptoberfläche (MS) des Halbleitersubstrats (S) größer ist als eine Dotierungskonzentration der zweiten Wanne (W2) innerhalb des Oberflächenbereichs, wodurch an der Hauptoberfläche (MS) eine Photonenerfassungsschicht (PC) mit dem zweiten Typ elektrischer Leitfähigkeit gebildet wird, wobei die Photonenerfassungsschicht (PC) seitlich in mindestens zwei Erfassungsabschnitte (CP1, CP2) getrennt ist, wobei ein p-n-Übergang (PND), der für die einfallende UV-Strahlung empfindlich ist, durch eine Grenze zwischen der zweiten Wanne (W2) und der Photonenerfassungsschicht (PC) gebildet wird;

- Anordnen eines Filters (F) über der Photonenerfassungsschicht (PC), wobei eine Durchlässigkeitscharakteristik des Filters (F) ein bestimmtes Erythemwirkungsspektrum emuliert;
- Ausbilden einer Abschwächungsschicht (ATL), die auf oder über der Hauptoberfläche (MS) angeordnet ist und dazu ausgelegt ist, dass sie sichtbare und infrarote Strahlung zumindest teilweise durchlässt und UV-Strahlung blockiert oder abschwächt;
- Verbinden eines ersten Messanschlusses (T1) mit dem mindestens einen ersten Erfassungsabschnitt (CP1) zum Messen eines ersten Kanalsignals in Abhängigkeit von einem Fotostrom, der durch UV-Strahlung erzeugt wird, die auf den mindestens einen ersten Erfassungsabschnitt (CP2) auftrifft;
- Verbinden eines Messanschlusses mit dem mindestens einen zweiten Erfassungsabschnitt (CP2) zum Messen eines zweiten Kanalsignals in Abhängigkeit von einem Fotostrom, der durch UV-Strahlung erzeugt wird, die auf den mindestens einen zweiten Erfassungsabschnitt (CP2) auftrifft; und
- Verbinden einer Prozessoreinheit mit dem ersten Messanschluss (T1) und dem zweiten Messanschluss, wobei die Prozessoreinheit eingerichtet ist, um eine Charakteristik des einfallenden Lichts in Abhängigkeit von einer Differenz zwischen einem von dem ersten Kanalsignal abhängigen Signal und einem von dem zweiten Kanalsignal abhängigen Signal zu bestimmen; wobei
- mindestens ein erster Erfassungsabschnitt (CP1) der mindestens zwei Erfassungsabschnitte (CP1, CP2) nicht durch die Abschwächungsschicht (ATL) abgedeckt ist; und
- mindestens ein zweiter Erfassungsabschnitt (CP2) der mindestens zwei Erfassungsabschnitte (CP1, CP2) durch die Abschwächungsschicht (ATL) abgedeckt ist.

6. Verfahren nach Anspruch 5, wobei der erste und der zweite Ionenimplantationsprozess retrograde Ionenimplantationsprozesse sind.

7. Verfahren nach einem der Ansprüche 5 oder 6, wobei die Erzeugung der Fotodiodenstruktur ferner die Durchführung eines dritten Ionenimplantationsprozesses nach dem ersten und dem zweiten Ionenimplantationsprozess umfasst, um eine Ladungsträgerkonzentration der Photonenerfassungsschicht (PC) zu erhöhen.

8. Verfahren nach einem der Ansprüche 5 bis 7, wobei der erste Typ der elektrischen Leitfähigkeit vom p-Typ ist und der zweite Typ der elektrischen Leitfähigkeit vom n-Typ ist.

**Revendications**

1. Dispositif de détection comprenant un substrat semi-conducteur (S) avec un premier type de conductivité électrique et une structure de photodiode pour détecter le rayonnement ultraviolet, UV, incident, la structure de photodiode comprenant

- un premier puits (W1) disposé à l'intérieur du substrat semi-conducteur (S) et présentant un second type de conductivité électrique ;
- un second puits (W2) disposé au moins partiellement à l'intérieur du premier puits (W1) et présentant le premier type de conductivité électrique, dans lequel une concentration de dopage du premier puits (W1) à l'intérieur d'une région de surface à une surface principale (MS) du substrat semi-conducteur (S) est supérieure à une concentration de dopage du second puits (W2) à l'intérieur de la région de surface, formant ainsi à la surface principale une couche de capture de photons (PC) ayant le deuxième type de conductivité électrique, dans laquelle la couche de capture de photons (PC) est séparée latéralement en au moins deux portions de capture (CP1, CP2)
- une jonction p-n (PND) pour détecter le rayonnement UV incident formé par une limite entre le deuxième puits (W2) et la couche de capture de photons (PC) ;
- un filtre (F) disposé au-dessus de la couche de capture de photons (PC), dans lequel une caractéristique de transmission du filtre (F) émule un spectre d'action érythémateux spécifié ;
- une couche d'atténuation (ATL) disposée sur ou au-dessus de la surface principale (MS) et configurée pour laisser passer au moins partiellement les rayonnements visibles et infrarouges et pour bloquer ou atténuer les rayonnements UV ;
- un premier terminal de détection (T1) connecté à la au moins une première portion de capture (CP1) pour mesurer un premier signal de canal dépendant d'un photocourant généré par le rayonnement UV incident sur la au moins une première portion de capture (CP1) ;
- un deuxième terminal de détection connecté à au moins une deuxième portion de capture (CP2) pour mesurer un deuxième signal de canal dépendant d'un photocourant généré par un rayonnement UV incident sur au moins une deuxième portion de capture (CP2) ; et

- une unité de traitement connectée au premier terminal de détection (T1) et au second terminal de détection et configurée pour déterminer une caractéristique de la lumière incidente en fonction d'une différence entre un signal dépendant du signal du premier canal et un signal dépendant du signal du second canal ; dans laquelle

- au moins une première portion de capture (CP1) des au moins deux portions de capture (CP1, CP2) n'est pas couverte par la couche d'atténuation (ATL) ; et

- au moins une deuxième portion de capture (CP2) des au moins deux portions de capture (CP1, CP2) est couverte par la couche d'atténuation (ATL).

2. Dispositif de détection selon la revendication 1, où le premier type de conductivité électrique est de type p et le second type de conductivité électrique est de type n.

3. Dispositif de détection selon l'une des revendications 1 à 2, dans lequel la jonction p-n (PND) présente une distance verticale par rapport à la surface principale (MS) comprise dans une plage de tolérance spécifiée autour d'une profondeur de pénétration maximale du rayonnement UV dans le substrat semi-conducteur (S).

4. Dispositif de détection selon la revendication 3, dans lequel

- une limite inférieure de la plage de tolérance est égale ou supérieure à 80 % de la profondeur de pénétration maximale ; et
- une limite supérieure de la plage de tolérance est égale ou inférieure à 150 % de la profondeur de pénétration maximale.

5. Méthode de fabrication d'un dispositif de capteur pour détecter le rayonnement UV incident, la méthode comprenant la fourniture d'un substrat semi-conducteur (S) avec un premier type de conductivité électrique et la génération d'une structure de photodiode, la génération de la structure de photodiode comprenant

- générer un premier puits (W1) disposé à l'intérieur du substrat semi-conducteur (S) et présentant un second type de conductivité électrique en réalisant un premier processus d'implantation ionique ;
- générer un second puits (W2) disposé au moins partiellement à l'intérieur du premier puits (W1) et présentant le premier type de conductivité électrique en réalisant un second processus d'implantation ionique, dans lequel une concentration de dopage du premier puits (W1) à l'intérieur d'une région de surface à une surface principale (MS) du substrat semi-conducteur (S) est supérieure à une concentration de dopage du second puits (W2) à l'intérieur de la région de surface, formant ainsi, à la surface principale (MS), une couche de capture de photons (PC) ayant le deuxième type de conductivité électrique, dans laquelle la couche de capture de photons (PC) est séparée latéralement en au moins deux portions de capture (CP1, CP2), dans laquelle une jonction p-n (PND) sensible au rayonnement UV incident est formée par une limite entre le deuxième puits (W2) et la couche de capture de photons (PC) ;
- disposer un filtre (F) au-dessus de la couche de capture de photons (PC), dans lequel une caractéristique de transmission du filtre (F) émule un spectre d'action érythémateux spécifié ;
- former une couche d'atténuation (ATL) disposée sur ou au-dessus de la surface principale (MS) et configurée pour laisser passer au moins partiellement les rayonnements visibles et infrarouges et pour bloquer ou atténuer les rayonnements UV ;
- connecter un premier terminal de détection (T1) à l'au moins une première portion de capture (CP1) pour mesurer un premier signal de canal dépendant d'un photocourant généré par le rayonnement UV incident sur l'au moins une première portion de capture (CP1) ;
- connecter un deuxième terminal de détection à au moins une deuxième portion de capture (CP2) pour mesurer un deuxième signal de canal dépendant d'un photocourant généré par un rayonnement UV incident sur au moins une deuxième portion de capture (CP2) ; et
- connecter une unité de traitement au premier terminal de détection (T1) et au second terminal de détection, l'unité de traitement étant configurée pour déterminer une caractéristique de la lumière incidente en fonction d'une différence entre un signal dépendant du signal du premier canal et un signal dépendant du signal du second canal ; dans lequel
- au moins une première portion de capture (CP1) des au moins deux portions de capture (CP1, CP2) n'est pas couverte par la couche d'atténuation (ATL) ; et
- au moins une deuxième portion de capture (CP2) des au moins deux portions de capture (CP1, CP2) est couverte par la couche d'atténuation (ATL).

6. Méthode selon la revendication 5, dans laquelle le premier et le second processus d'implantation ionique sont des processus d'implantation ionique rétrograde.

7. Méthode selon l'une des revendications 5 ou 6, dans laquelle la génération de la structure photodiode comprend en outre l'exécution d'un troisième processus d'implantation ionique après le premier et le deuxième processus d'implantation ionique afin d'augmenter la concentration des porteurs de la couche de capture des photons (PC).

8. Méthode selon l'une des revendications 5 à 7, dans laquelle le premier type de conductivité électrique est de type p et le deuxième type de conductivité électrique est de type n.

FIG. 1

FIG. 2

FIG. 3

FIG. 4

FIG. 5

FIG. 6

## FIG. 7A

## FIG. 7B

## FIG. 8A

## FIG. 8B

## FIG. 9A

## FIG. 9B

**REFERENCES CITED IN THE DESCRIPTION**

**Patent documents cited in the description**

- EP 0387483 A1
- WO 9729517 A2
- US 20130341690 A1